# EUROPEAN PATENT SPECIFICATION

(11) **EP 0 670 760 B1**
(45) Date of publication and mention of the grant of the patent: **24.03.1999**
(21) Application number: 93918432.1
(22) Date of filing: 21.07.1993
(51) Int. Cl.: B23K 31/02, H01R 43/02, H01R 23/72, H05K 3/34

(54) **ELECTRICAL CONNECTOR**
ELEKTRISCHER VERBINDER
CONNECTEUR ELECTRIQUE

(30) Priority: 25.11.1992 JP 81224/92
(43) Date of publication of application: 13.09.1995
(73) Proprietor: BERG ELECTRONICS MANUFACTURING B.V., 5222 AV s'-Hertogenbosch (NL)
(72) Inventor: LWEE, Nai, Hock, Singapore 0512555 (SG); KIN, Loke Wing, Singapore 1953 (SG); SUAT, Ng Bee, Singapore 0512 (SG)
(74) Representative: BROOKES & MARTIN
(86) International application number: US9307064
(87) International publication number: WO9412311

(56) References cited:
- US-A- 3 989 331
- US-A- 4 010 992
- US-A- 4 872 845

## Description

The present invention relates to an electrical connector assembly for connecting circuit boards.

A mother board has a plastic connector housing on its surface side for a conventional vertical card connector. The mother board is connected to a daughter card via vertically inserted plugs in the plastic connector housing at the edge of the daughter card. Contact terminals are located in the housing, and each contact terminal has a contact beam for making electrical contact with a corresponding plug of the daughter card. Each contact terminal also includes a solder tail to be soldered to the mother board. Basic functions of the contact beam are to receive the daughter card plug for making an electrical connection and holding the plug in place.

One known process for mounting such a connector on the mother board is as follows: The solder tail of the contact terminal is inserted into a corresponding through hole of the mother board. The mother board is inverted so that the housing is set on a "down" side and the solder tails on an "up" side. The solder tails are soldered to the mother board by applying melted solder to the solder tails on the soldering side of the mother board.

During the above steps, since an amount of melted solder flowing onto the solder tail is not controlled, more than necessary melted solder may be supplied to the solder tail. Melted solder will flow down the solder tail into the mother board and toward the plastic connector housing. Melted solder may also flow inside the connector reaching the contact beam. In such a situation, excess solder narrows the plug receiving gap in the connector terminal. Ultimately, the excess solder will impair a basic function of the connector terminal by not fitting a plug.

Another prior-art process for mounting the aforementioned connector on a mother board is as follows:

The solder tail of the contact terminal is inserted into a through hole of the mother board. The mother board and connector terminal pass through a wave soldering machine while the mother board is held in such a way that the solder tail faces downwards. The wave soldering machine forces melted solder to go upward form the bottom of the connector terminals towards the connector housing through the mother board. Since the connector terminal is very short, pressure acting upon the melted solder causes the solder to penetrate into the connecting housing. As a result, the melted solder still may reach the contact beam and impair the basic function of the contact beam.

US-A-3 989 331 discloses an electrical assembly usable to connect first and second circuit boards together via a plurality of interengageable contacts.

As is known from US-A-3 989 331, the present invention provides an electrical connector assembly usable to connect a first and a second circuit board together via a plurality of interengageable contacts said assembly comprising:
a housing located on the first circuit board, the housing having a bottom surface and a top surface relative to the first circuit board;
a plurality of contacts mounted in the housing and having terminals extending from the bottom surface of the housing into through holes in the first circuit board, the contacts in the housing being accessible from the top surface of the housing to mate with complementary contacts connected to the second circuit board and
a heat-resistant insulating resin sheet located between the bottom surface of the housing and the first circuit board and serving to prevent excess solder from entering the housing when molten solder is applied to the terminals to solder the terminals into the holes in the first circuit board.

In contrast to US-A-3 989 331 and in accordance with the invention, the housing has a least one projection extending outwardly from the bottom surface of the housing. This projection creates a space between the bottom surface of the housing and the sheet. The space thus created establishes a pathway to permit the escape of corrosion-causing gas due to evaporation of a cleaning medium after a wash process to clean the first circuit board.

The contact terminals can penetrate through the sheet.

The housing can be provided with at least another projection extending outwardly from the bottom surface and serving to co-operate with the sheet and create a further space between the sheet and the first circuit board which acts as a further pathway. The further pathway allows escape of corrosion acid gas formed from the flux of the molten solder aswell as the escape of the evaporating cleaning medium.

In a preferred construction the housing has several projections which provide both spaces and hence pathways between the sheet and the housing between the sheet and the first circuit board.

The projections which create the space between the first circuit board and the sheet may have the sheet wrapped therearound and may take the form of ridges at the ends of the bottom surface. Projections in the form of bumps between the ridges can produce the space between the housing bottom surface and the sheet. The sheet itself can be larger than the bottom surface.

Additional features and advantages of the invention may become apparent from the following description.

The accompanying drawings which are incorporated in and constitute a part of the specification illustrate a presently preferred embodiment of the invention. Together with the general description given above and the detailed description of the preferred embodiment given below, the drawings serve to explain the principles of the invention.
Fig. 1 illustrates a side view of an electrical connector according to an embodiment of the present invention;
Fig. 2 shows a top view of the electrical connector shown in Fig. 1;
Fig. 3 shows an enlarged portion of a connector indicated by III in Fig. 1;
Fig. 4 shows an end view of the electrical connector of Fig. 1; and
Fig. 5 shows a top view of a layout of plated through holes in a mother board of Fig. 1.

### Detailed Description of the Preferred Embodiment

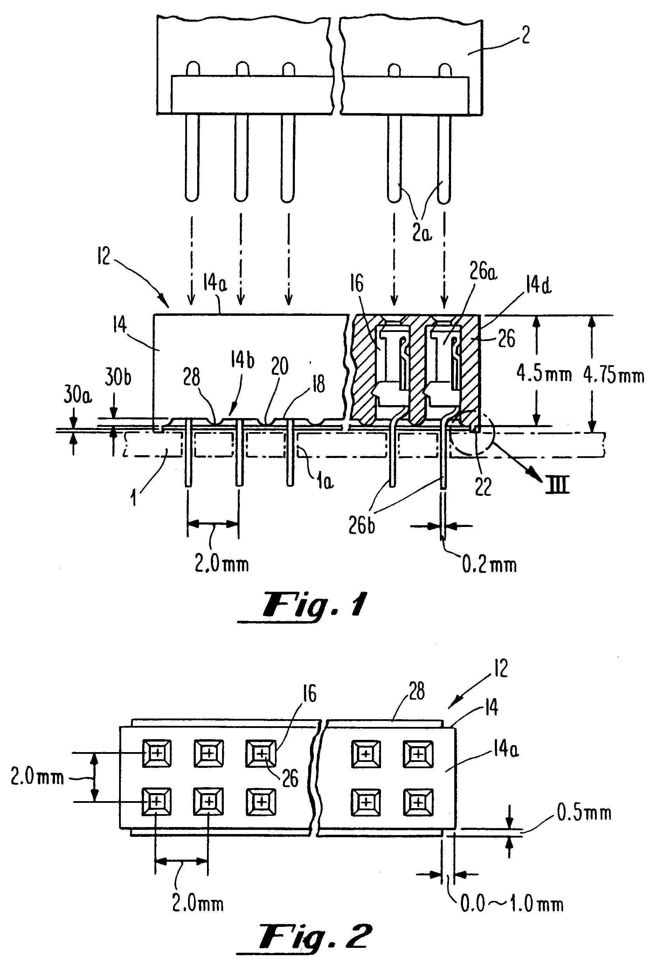

Referring to Fig. 1, an electrical connector or vertical card connector 12 connects a printed circuit board 1 to a printed circuit board 2 in a substantially vertical relation. The connector 12 has an elongated housing 14 in which a plurality of contact terminal receiving spaces 16 are provided. The housing 14 is made of a material having a desired electrical insulating property such as a glass-filled PBT.

Each contact terminal receiving space 16 extends from an upper surface 14a to a bottom surface 14b of the housing 14. As shown in Fig. 2, the contact terminal receiving spaces 16 are arranged in a parallel array as seen on the upper surface 14a of the housing 14.

Referring back to Fig. 1, a plurality of recesses 18 is provided across the bottom surface 14b of the housing 14 which coincides the array of contact terminal receiving spaces 16. A first ridge or projection 22 is provided at each end of the bottom surface 14b of the housing 14. A plurality of second ridges or projections 20 are provided at each end of the recess 18 including at the both ends of the bottom surface 14b of the housing 14. The first ridge 22 adds an additional height to the second ridge 20.

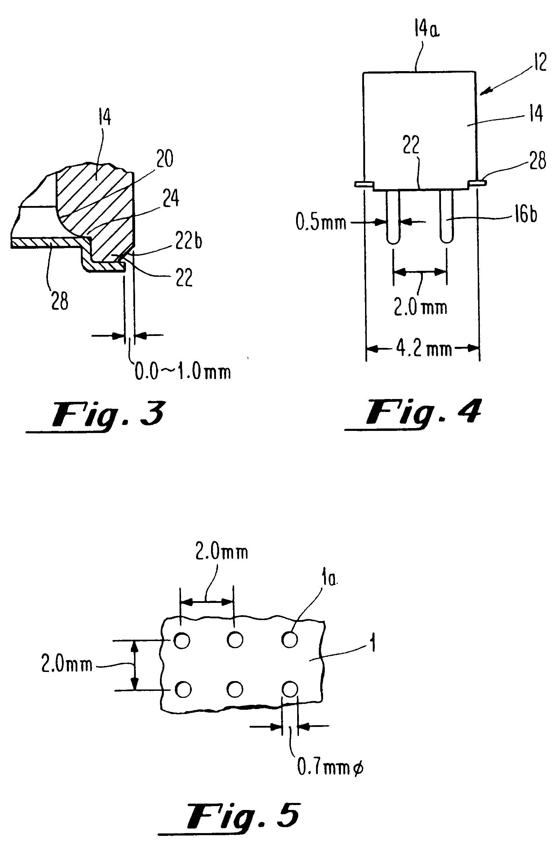

Fig. 3 shows an enlarged cross-section of the second ridge 20 and the first ridge 22 at the end of the housing 14. An inner wall 22a of the first ridge 22 is made substantially vertical to the bottom surface 14b of the housing 14. The inner wall 22a of the first ridge 22 merges with the second ridge 20 at each end of the housing 14. A shoulder 24 is provided at a merging area between the second ridge 20 and the inner wall 22a of the first ridge 22. The shoulder 24 is projected relative to the recess 18 as much as other second ridges 20 are. An outer wall 22b of the first ridge 22 is rounded toward the inner wall 22a side of the first ridge 22.

According to one embodiment, the housing 14 has a width of 4.2 mm and a height of 4.5 mm between the second ridge 20 and the upper surface of the housing 14. The first ridge 22 adds 0.25mm in height beyond the second ridge 20. Thus, the housing 14 has a total height of 4.75 mm between the first ridge 22 and the upper surface of the housing 14.

A female contact terminal 26 is placed in a contact terminal receiving space 16 as shown in Figs. 1 and 2. The contact terminal 26 is of a conventional type for a conventional vertical connector. Each contact terminal 26 is formed of a sheet metal such as phosphor bronze having desired conductive and elastic properties. The contact terminal 26 has a contact beam 26a for establishing electrical contact with a plug 2a of a daughter card 2. A solder tail 26b is inserted into a plated bore 1a on the mother board 1 and is soldered therein. The contact beam 26a substantially extends from the upper surface 14a to the bottom surface 14b of the housing 14 while the solder tail 26b extends vertically from the bottom surface 14b of the housing 14 through the bore 1a to the other side of the mother board 1. The contact beam 26a may take various shapes whereby it is possible to hold the plug 2a of a daughter card 2 in place with an elastic action. Since the form of the contact beam 26a is known in the "contact" field of art, any detailed explanation is omitted.

As shown in Figs. 2 and 4, in a preferred embodiment, each solder tail 26b is approximately 0.2 mm as viewed along the length of the housing 14 and 0.5 mm as viewed along the width of the housing 14. The array pitch of the contacts 26 is 2 mm x 2 mm as shown in Figures 2 and 5. According to a preferred embodiment, the plated bores 1a of the mother board 1 are so arranged to accept the solder tails 26b as shown in Fig. 5. The plated bore 1a has a diameter of 0.7 mm, and the mother board 1 has a thickness of 0.9 mm to 1.3 mm.

As shown in Figs. 1 and 4, the bottom surface 14b of the housing 14 is covered with a sheet, tape or film 28 which is made of a heat-resisting insulating resin. The solder tail 26b extends through or pierces the film 28.

The insulating resin material in the film 28 has a high melting point so that it does not melt when melted solder contacts its surface. One heat-resisting insulating film which is particularly suited for this purpose is a polyamide film known under the trade mark "Kapton," manufactured by E.I DuPont de Nemours & Company.

The film 28 extends along the peaks of the second ridges 20 in the housing 14. At the end of the housing, end portions the film 28 are bent substantially perpendicularly and covers along the inner wall 22a of the first ridge 22 at the shoulder 24. The film 28 is then again bent substantially perpendicularly at the forward end of the inner wall 22a toward the outer wall 22b of the first ridge 22 as shown in Figure 3. Since, as discussed above, the extension length of the first ridge 22 beyond the second ridge 20 is approximately 0.25 mm, the film 28 is placed 0.25 mm inside the bottom surface defined by the top of the first ridge 22. Here, the film 28 is very thin on the order of 0.025 mm even though it is shown out of proportion with respect to other elements in figures.

The film 28 extends beyond an edge of the housing. The horizontal distance between the end of the film 28 and the longitudinal end of the housing 14 ranges from 0 to 1.0 mm according to one embodiment as shown in Fig. 3. The width of the film 28 is 43 mm while the width of the housing is 42 mm. The width of the film 28 is 0.5 mm greater at each side of the housing 14 as shown in Figure 2. The excess portions of the film 28 makes the manufacturing process easier, and the size of the film 28 is not restricted only to the aforementioned size.

The film 28 serves as a barrier during a soldering step of the solder tail 26b. Melted solder is prevented from flowing into a recess 18, a contact terminal receiving area 16 or a contact terminal 26. In addition, according to the present embodiment, since the film 28 is placed at least 0.25 mm above the mother board, a first gap 30a is created between the bottom surface of the film 28 and the surface of the mother board. Further, due to the presence of the recess 18, a second gap 30b is created between the top surface of the film 28 and the bottom surface 14b of the housing 14. A better soldering bond is achieved since an acid gas evolved from a flux used for soldering the solder tail 26b escapes from the first gap 30a.

The experiments have revealed that when melted solder reaches the solder tails 26b and the plated bore 1a in the mother board, an acid gas evolving from the melted solder cannot escape from the solder and stays therein. This cannot satisfy a requisite solder filling specification. Further after time lapses, the acid gas fills in the housing 14, and the contact terminal 26 is corroded. This corrosion causes a connection failure. Thus, the gap substantially prevents the corrosion of the contact terminal by escaping the acid gas. In addition, the gaps 30a and 30b also enable to readily evaporate water-based cleaning medium. When circuit board are assembled and soldered as described above according to the current invention, the circuit boards are washed with water-based cleaning medium to remove undesirable material on the board. Although non-water-based cleaning medium may be used, for the reasons of the cost and environmental concerns, more water-based cleaning medium is used these days. The gaps 30a and 30b together substantially improve the evaporation of the residual cleaning medium. Without these gaps, corrosion of the contact terminals due to the residual cleaning medium occurs.

Although, in the aforementioned embodiment, the dimension of each part of the electrical connector 12 has been explained by way of example, various design modifications can be made according to the present invention. Further, the electrical connector 12 to which the present invention is applied is not restricted to the vertical card connector 12. The current invention can also be applied to other electrical connectors which allow the insertion of a plurality of plugs.

As set out above, according to the present invention, the characteristic of the contact is not destroyed because the heat-resisting insulating resin sheet prevents a melted solder from flowing past the solder tails into the housing when the solder tail of the contact is soldered. An undesirable acid gas evolving from the solder is removed by the gap created by the projection.

Additional advantages and modifications may be available by those skilled in the art. Therefore, the invention in its broader aspects is not limited to the specific details and representative devices shown and described herein. Accordingly, various modifications may be made without departing from the scope of the invention as defined by the appended claims.

## Claims

1. An electrical connector assembly usable to connect a first and a second circuit board (1,2) together via a plurality of interengageable contacts (2a, 2b) said assembly comprising:
a housing (14) located on the first circuit board (1), the housing (14) having a bottom surface (14b) and a top surface (14a) relative to the first circuit board (1);
a plurality of contacts (26) mounted in the housing (14) and having terminals extending from the bottom surface (14b) of the housing (14) into through holes (1a) in the first circuit board (1), the contacts (26) in the housing being accessible from the top surface (14a) of the housing (14) to mate with complementary contacts connected to the second circuit board (2) and
a heat-resistant insulating resin sheet (28) located between the bottom surface (14b) of the housing (14) and the first circuit board (1) and serving to prevent excess solder from entering the housing when molten solder is applied to said terminals to solder the terminals into the holes (1a) in the first circuit board (1); characterised in that the housing (14) is provided with at least one projection (20) extending outwardly from the bottom surface (14b) to create a space (30b) between the bottom surface (14b) and the sheet (28) which acts as a pathway to permit the escape of corrosion-causing gas due to evaporation of a cleaning medium after a wash process to clean the first circuit board (1).

2. An assembly according to claim 1, wherein the housing (14) is provided with at least another projection (22) extending outwardly from the bottom surface (14b) and serving to co-operate with the sheet (28) and to create a further space (30a) between the sheet (28) and the first circuit board (1) which acts as a further pathway to permit the escape of corrosion-causing gas generated by the molten solder.

3. An assembly according to claim 2, wherein the further space (30a) also acts as a further pathway for the escape of the corrosion causing gas due to the evaporation of the cleaning medium.

4. An assembly according to claim 2 or 3 wherein the sheet (28) is wrapped around said at least other projection (22).

5. An assembly according to claim 2, 3 or 4, wherein said at least other projection is a ridge (22) located at an end of the bottom surface (14b).

6. An assembly according to claim 5 wherein there are a pair of such ridges (22) at both ends of the bottom surface (14b).

7. An assembly according to any one of claims 1 to 6, wherein said at least one projection is a bump (20) intermediate the ends of the bottom surface (14b).

8. An assembly according to claim 2 or 3, wherein said at least other projection takes the form of a pair of ridges (22) at the ends of the bottom surface (14b) and said at least one projection (20) takes the form of a plurality of spaced apart bumps (20) between the ridges (22), the sheet (28) extending between the bumps (20) and being wrapped around the ridges (22) to extend further outwardly from the bottom surface (14b).

9. An assembly according to any one or more of the preceding claims wherein the sheet (28) is larger than the bottom surface (14b) and extends in at least one direction beyond the bottom surface (14b).

10. An assembly according to any one or more of the preceding claims wherein the terminals pierce through the sheet (28).

11. An assembly according to any one or more of the preceding claims wherein the sheet is 'Kapton®' tape.

## Patentansprüche

1. Elektrische Verbinderanordnung, welche zum Verbinden einer ersten und einer zweiten Leiterplatte (1, 2) miteinander über eine Mehrzahl von miteinander in Eingriff bringbaren Kontakten (2a, 2b) verwendbar ist, wobei die Anordnung umfaßt:
ein Gehäuse (14), welches an der ersten Leiterplatte (1) angeordnet ist, wobei das Gehäuse (14) eine untere Oberfläche (14b) und eine obere Oberfläche (14a) bezüglich der ersten Leiterplatte (1) aufweist,
eine Mehrzahl von Kontakten (26), welche in dem Gehäuse (14) angeordnet sind und Anschlüsse aufweisen, welche sich von der unteren Oberfläche (14b) des Gehäuses (14) in Durchgangslocher (1a) in der ersten Leiterplatte (1) erstrecken, wobei die Kontakte (26) in dem Gehäuse von der oberen Oberfläche (14a) des Gehäuses (14) zum Ineingriffbringen mit komplementären Kontakten zugänglich sind, welche mit der zweiten Leiterplatte (2) verbunden sind, und
eine wärmebeständige, isolierende Harzlage (28), welche zwischen der unteren Oberfläche (14b) des Gehäuses (14) und der ersten Leiterplatte (1) angeordnet ist und dazu dient, zu Verhindern, daß überschüssiges Lötmittel in das Gehäuse eintritt, wenn geschmolzenes Lötmittel auf die Anschlüsse zum Löten der Anschlüsse in die Löcher (1a) in der ersten Leiterplatte (1) aufgebracht wird,
dadurch gekennzeichnet,
daß das Gehäuse (14) wenigstens einen Vorsprung (20) aufweist, welcher sich von der unteren Oberfläche (14b) nach außen erstreckt, um einen Raum (30b) zwischen der unteren Oberfläche (14b) und der Lage (28) zu bilden, welcher als ein Durchgang dient, um das Entweichen von korrosionsverursachendem Gas aufgrund des Verdunstens eines Reinigungsmediums nach einem Waschvorgang zum Reinigen der ersten Leiterplatte (1) zu ermöglichen.

2. Anordnung nach Anspruch 1, worin das Gehäuse (14) wenigstens einen weiteren Vorsprung (22) aufweist, welcher sich von der unteren Oberfläche (14b) nach außen erstreckt und zum Zusammenwirken mit der Lage (28) und zum Bilden eines weiteren Raums (30a) zwischen der Lage (28) und der ersten Leiterplatte (1) dient, welcher als ein weiterer Durchgang zum Ermöglichen des Entweichens von korrosionsverursachendem Gas dient, das durch das geschmolzene Lötmittel erzeugt wird.

3. Anordnung nach Anspruch 2, worin der weitere Raum (30a) ferner als ein weiterer Durchgang zum Entweichen von korrosionsverursachendem Gas aufgrund des Verdunstens des Reinigungsmediums dient.

4. Anordnung nach Anspruch 2 oder 3, worin die Lage (28) um den wenigstens einen Vorsprung (22) gelegt ist.

5. Anordnung nach Anspruch 2, 3 oder 4, worin der wenigstens eine Vorsprung eine Rippe (22) ist, welche an einem Ende der unteren Oberfläche (14b) angeordnet ist.

6. Anordnung nach Anspruch 5, worin ein Paar derartiger Rippen (22) an beiden Enden der unteren Oberfläche (14b) vorgesehen ist.

7. Anordnung nach einem der Ansprüche 1 bis 6, worin der wenigstens eine Vorsprung ein Höcker (20) zwischen den Enden der unteren Oberfläche (14b) ist.

8. Anordnung nach Anspruch 2 oder 3, worin der wenigstens eine weitere Vorsprung die Form eines Paars von Rippen (22) an den Enden der unteren Oberfläche (14b) aufweist und der Wenigstens eine Vorsprung (20) die Form einer Mehrzahl zueinander im Abstand liegender Höcker (20) zwischen den Rippen (22) aufweist, wobei die Lage (28) sich zwischen den Höckern (20) erstreckt und um die Rippen (22) gelegt ist, so daß sie sich weiter von der unteren Oberfläche (14b) nach außen erstreckt.

9. Anordnung nach einem oder mehreren der vorangehenden Ansprüche, worin die Lage (28) größer ist als die untere Oberfläche (14b) und sich in wenigstens einer Richtung über die untere Oberfläche (14b) hinaus erstreckt.

10. Anordnung nach einem oder mehreren der vorhergehenden Ansprüche, worin die Anschlüsse die Lage (28) durchstechen.

11. Anordnung nach einem oder mehreren der vorhergehenden Ansprüche, worin die Lage 'Kapton®'-Band ist.

## Revendications

1. Ensemble de connecteur électrique pouvant être utilisé pour connecter ensemble une première et une seconde cartes de circuits imprimés (1,2) par l'intermédiaire d'une pluralité de contacts pouvant s engager mutuellement (2a, 2b), ledit ensemble comprenant :
un logement (14) placé sur la première carte de circuits (1), le logement (14) comportant une surface inférieure (14b) et une surface supérieure (14a) par rapport à la première carte de circuits (1) ;
une pluralité de contacts (26) montés dans le logement (14) et comportant des bornes s'étendant à partir de la surface inférieure (14b) du logement (14) dans des trous de passage (1a) présents dans la première carte de circuits (1), les contacts (26) du logement étant accessibles à partir de la surface supérieure (14a) du logement (14) pour s ajuster à des contacts complémentaires connectés à la seconde carte de circuits (2) et
une feuille de résine isolante résistante à la chaleur (28) placée entre la surface inférieure (14b) du logement (14) et la première carte de circuits (1) et servant à empêcher la soudure en excès d'entrer dans le logement lorsqu'une soudure fondue est appliquée auxdites bornes pour souder les bornes dans les trous (1a) de la première carte de circuits (1) ; caractérisé en ce que le logement (14) est prévu avec, au moins, une partie en saillie (20) s'étendant vers l'extérieur à partir de la surface inférieure (14b) pour créer un espace (30b) entre la surface inférieure (14b) et la feuille (28) qui agit comme un passage pour permettre l'évacuation d'un gaz corrosif, dû à l'évaporation du produit nettoyant après un procédé de lavage servant à nettoyer la première carte de circuits (1).

2. Ensemble selon la revendication 1, dans lequel le logement (14) est prévu avec, au moins, une autre partie en saillie (22) s'étendant vers l'extérieur à partir de la surface inférieure (14b) et destinée à coopérer avec la feuille (28) et à créer un autre espace (30a) entre la feuille (28) et la première carte de circuits (1) lequel agit en tant que passage supplémentaire pour permettre l'évacuation du gaz corrosif généré par la soudure fondue.

3. Ensemble selon la revendication 2, dans lequel l'espace supplémentaire (30a) agit également comme un autre passage servant à l'évacuation du gaz corrosif dû à l'évaporation du milieu nettoyant.

4. Ensemble selon la revendication 2 ou 3, dans lequel la feuille (28) est enroulée autour de ladite (desdites) autre(s) partie(s) en saillie.

5. Ensemble selon la revendication 2, 3 ou 4, dans lequel ladite (lesdites) autre(s) partie(s) en saillie est (sont) une nervure (22) placée à une extrémité de la surface inférieure (14b).

6. Ensemble selon la revendication 5, dans lequel il existe une paire de telles nervures (22) situées aux deux extrémités de la surface inférieure (14b).

7. Ensemble selon l'une quelconque des revendications 1 à 6, dans lequel ladite (lesdites) partie(s) en saillie corresponde(nt) à un bossage (20) placé entre les extrémités de la surface inférieure (14b).

8. Ensemble selon la revendication 2 ou 3, dans lequel ladite (lesdites) autre(s) partie(s) en saillie présente(nt) la forme d'une paire de nervures (22) aux extrémités de la surface inférieure (14b) et ladite (lesdites) partie(s) en saillie (20) prend (prennent) la forme d'une pluralité de bossages espacés les uns des autres (20) entre les nervures (22), la feuille (28) s'étendant entre les bossages (20) et étant enroulée autour des nervures (22) afin de s'étendre davantage vers l'extérieur par rapport à la surface inférieure (14b).

9. Ensemble selon l'une quelconque, ou davantage, des revendications précédentes dans lequel la feuille (28) est plus grande que la surface inférieure (14b) et s'étend dans au moins une direction, au-delà de la surface inférieure (14b).

10. Ensemble selon l'une quelconque, ou davantage, des revendications précédentes dans lequel les bornes percent la feuille (28).

11. Ensemble selon l'une quelconque, ou davantage, des revendications précédentes dans laquelle la feuille est une bande de "Kapton^{R}".
